# EUROPEAN PATENT APPLICATION

(11) **EP 3 561 986 A1**
(43) Date of publication of application: **30.10.2019**
(21) Application number: 17883492.5
(22) Date of filing: 13.12.2017
(51) Int. Cl.: H02J 3/38, H02J 9/00, G01R 31/08

(54) **PCS FOR ESS AND PCS OPERATING METHOD**

(30) Priority: 21.12.2016 KR 20160176083
(71) Applicant: Hyosung Heavy Industries Corporation, Seoul 04144 (KR)
(72) Inventor: JUNG, Sang Min, Seoul 08305 (KR); JIN, Bo Gun, Anyang-si Gyeonggi-do 14103 (KR); JIN, Dae Geun, Incheon 22187 (KR)
(74) Representative: Viering, Jentschura & Partner mbB Patent- und Rechtsanwälte
(86) International application number: PCT/KR2017/014643
(87) International publication number: WO 2018/117530

(57) **Abstract**

Disclosed is a fault processing method of a microgrid having a plurality of distributed energy resources, a plurality of distributed loads, lines that connect the distributed energy resources and the distributed loads, and an energy storage system (ESS) that stores power supplied from a part or all of the distributed energy resources and supplies the stored power to a part or all of the distributed loads, the fault processing method comprising steps of: disconnecting the distributed energy resources and an ESS power conditioning system (ESS-PCS) responsible for the ESS when a fault is detected in the microgrid system; connecting the ESS-PCS to the microgrid; determining a location of the fault while gradually increasing a voltage output from the ESS-PCS; and disconnecting the location of the fault and boosting the voltage output from the ESS-PCS to a normal operation level.

## Description

### TECHNICAL FIELD

The present invention relates to a power conditioning system (PCS) for an energy storage system (ESS) and a method of operating the PCS for fault processing, and more particularly, to an ESS-PCS and a method of operating the PCS, capable of reducing a dead time of a serviceable section suffering from unnecessary outage when a fault occurs in a microgrid system including the ESS.

### BACKGROUND ART

A microgrid is known as a small energy resource system including distributed energy resources (such as a photovoltaic resource or a wind turbine) and batteries (energy storage devices) to supply power to a load. In a normal state, the microgrid is interconnected to a large-scale grid and is operated in an interconnected operation mode to trade energy. When a fault occurs in a line of the service provider side, the microgrid is disconnected from the energy system and is converted into an independent operation mode in which energy is independently supplied. In general, the microgrid is installed in a building, a university campus, a factory, or the like in order to save an energy cost and improve energy supply reliability. Meanwhile, when the microgrid is installed in a remote place such as an island area, the microgrid is operated to form a single system in combination with internal loads without interconnection with any external energy system.

In order to improve energy supply reliability as one of the microgrid installation objectives, it is necessary to operate the microgrid in an uninterruptible manner. When a fault occurs in the energy system, it is necessary to accurately detect the fault and disconnect the microgrid from the upper-layer energy system as soon as possible. In addition, when a fault occurs inside the microgrid, it is necessary to immediately disconnect only the corresponding part to prevent outage. Meanwhile, a magnitude and a direction of the fault current changes depending on an interconnection state between the microgrid and the energy system, including an interconnection state of each distributed energy resource, a fault location, a fault type, or the like. However, the existing circuit breaker (such as a moduled case circuit breaker (MCCB) or an air circuit breaker (ACB)) and the existing fault processing method failed to appropriately cope with various fault types occurring in the microgrid. In some cases, a local fault may affect the entire microgrid, thereby resulting in outage of the entire system. In particular, such disadvantages more frequently occur in the case of a microgrid system installed in an island area or the like having an independent network.

Meanwhile, a general microgrid system including those installed in remote places has an energy storage system (ESS) for coping with outage or a generator fault and compensating for imbalance of the load. However, the ESS installed in the microgrid system of the prior art merely stores and discharges remaining energy, and fails to perform active operation for the microgrid system.

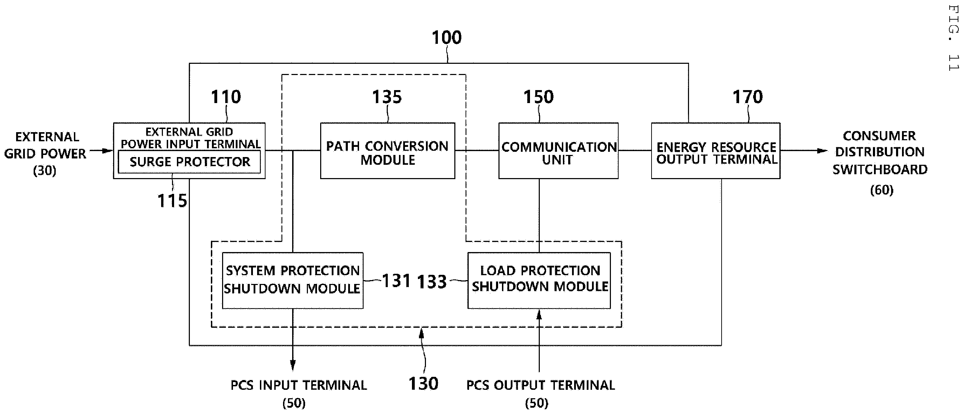

FIG. 11 is a schematic block diagram illustrating a gateway-integrated PCS applicator a microgrid interconnected to an external grid of the prior art. The microgrid system provided with the gateway-integrated PCS of FIG. 11 has a bidirectional meter for a renewable energy generation facility and an external energy resource.

The illustrated gateway-integrated PCS has a PCS gateway 100 and a PCS 50. The PCS gateway 100 generally includes an external grid energy input terminal 110, an energy resource output terminal 170, a communication unit 150, and a bypass path setting unit 130.

The external grid energy input terminal 110 is supplied with external grid energy 30, and the energy resource output terminal 170 supplies external grid energy 30 or energy of the PCS 50 to the consumer distribution switchboard 60.

The communication unit 150 is placed in the vicinity of the energy resource output terminal 170 or is integrated to the energy resource output terminal 170. The communication unit 150 transmits or receives energy information data to/from the bidirectional meter 20 and the PCS 50. In addition, the communication unit 150 transmits or receives energy information data to/from an energy control center (not shown) on the basis of various wired/wireless communication schemes.

The bypass path setting unit 130 connects the external grid energy 30 and the PCS 50 in series and forms an energy supply path for supplying energy to the consumer distribution switchboard 60 via the PCS 50 or forms a bypass energy supply path by directly connecting external grid energy 30 to the consumer distribution switchboard 60.

For this purpose, the bypass path setting unit 130 may include a system protection shutdown module 131, a load protection shutdown module 133, and a path switching module 135. The load protection shutdown module 133 connects the external grid energy 30 and the input terminal of the PCS 50 via the external grid energy input terminal 110, and the system protection shutdown module 131 connects the output terminal of the PCS 50 and the consumer distribution switchboard 60 via the energy resource output terminal 170, so as to substantially form series connection between the external grid energy 30 and the PCS 50 and provide an energy supply path through which the external grid energy 30 is supplied to the consumer distribution switchboard 60 via the PCS 50.

The path switching module 135 is connected via the external grid energy input terminal 110, and the bypass path setting unit 130 forms a bypass energy supply path by directly connecting the external grid energy 30 to the consumer distribution switchboard 60 via the energy resource output terminal 170.

The bypass path setting unit 130 may further include a control module (not shown) for operating the system protection shutdown module 131, the load protection shutdown module 133, and the path switching module 135 in order to monitor an operation state of the PCS 50 and form an energy supply path depending a result of the monitoring.

The external grid energy input terminal 110 may include a surge protector 115 for cutting off a surge input though an external power line. The surge protector 115 is a device capable of effectively protecting the PCS gateway 100 and the PCS 50. Although the external grid energy input terminal 110 includes the surge protector 115 in the drawings, the surge protector 115 may be optionally placed in various locations in a start portion of the energy supply path where the external grid energy 30 is input.

The PCS 50 may be connected to the renewable energy generation system and the ESS to supply energy to the consumer distribution switchboard 60 or the external grid or store external grid energy 30 in the ESS.

The illustrated PCS gateway 100 of the gateway-integrated PCS is placed between the external grid energy 30 and the PCS 50. In a normal operation of the PCS 50, the PCS gateway 100 sets a serial energy path from the external grid energy 30 to the consumer distribution switchboard 60 via the PCS 50. However, in a case where a trouble occurs in the PCS 50, the PCS gateway 100 forms a bypass path to set an energy supply path directly connected from the external grid energy 30 to the consumer distribution switchboard 60.

However, the gateway-integrated PCS of FIG. 11 is just a passive device that merely converts the energy transmission path and fails to provide any solution for a fault occurring in the grid. In addition, the gateway-integrated PCS is not suitable for a microgrid system of a remote place having an independent grid.

### SUMMARY OF INVENTION

An object of the invention is to provide a microgrid or a fault processing method, capable of rapidly detecting a fault location and providing a solution. More specifically, the invention proposes a method of detecting a fault location using the ESS and disconnecting and recovering the fault location when a line fault or a device fault occurs in an off-grid environment.

An object of the invention is to improve reliability by stably operating the system of the microgrid. For this purpose, a fault location is rapidly detected, and the fault location is disconnected using the ESS-PCS.

According to an aspect of the invention, there is provided a power conditioning system (PCS) for an energy storage system (ESS) that receives and stores power remaining in a grid and provides the stored power in a power shortage state of the grid, the ESS-PCS performing power conditioning and mediation in the grid, the ESS-PCS including: a circuit breaker configured to disconnect a line connected to the grid; and a control device configured to detect a fault in the grid and check a location of the fault while gradually increasing a voltage of power output to the grid where the fault is detected.

Here, the control device may boost the voltage of the power output to the grid, that has gradually increased for the fault location detection, to a normal operation level depending on a location of the fault and a processing result.

Here, the control device may determine a location of the fault in a microgrid while gradually increasing the voltage output from the active PCS immediately after re-connection to the grid that has been disconnected due to occurrence of the fault, and transmit information regarding the determined location to a management device.

Here, the control device may performs a PCS operation method including steps of disconnecting a line connected to the grid when a fault is detected in the grid, checking whether or not the ESS-PCS is normally operated, connecting the ESS-PCS to the grid and determining a location of the fault while gradually increasing a voltage output to the connected grid, transmitting information regarding the fault location detection to a management device of the grid, and boosting the voltage output to the grid to a normal operation level in response to an instruction of the management device.

Here, the step of determining a location of the fault may include steps of checking whether or not the PCS is normally operation as the ESS-PCS is connected to the grid, and checking whether or not there is a fault in a line/load side by monitoring a current of the grid while gradually increasing a voltage supplied to the ESS-PCS if it is determined that the ESS-PCS is normally operated.

Here, the step of connecting the ESS-PCS to the grid may include closing a DC terminal switch that switches on/off connection between an inverter and a battery of the ESS, closing an AC terminal switch that switches on/off connection between a microgrid and an inverter of the ESS, and closing an Insulated gate bipolar transistor (IGBT) included in the inverter.

Here, the ESS-PCS may further include a data communication unit configured to transmit information regarding the location of the fault to a management device.

According to another aspect of the invention, there is provided a fault processing method of a microgrid having a plurality of distributed energy resources, a plurality of distributed loads, lines that connect the distributed energy resources and the distributed loads, and an energy storage system (ESS) that stores power supplied from a part or all of the distributed energy resources and supplies the stored power to a part or all of the distributed loads, the fault processing method including steps of: disconnecting the distributed energy resources and an ESS power conditioning system (ESS-PCS) responsible for the ESS when a fault is detected in the microgrid system; connecting the ESS-PCS to the microgrid; determining a location of the fault while gradually increasing a voltage output from the ESS-PCS; and disconnecting the location of the fault and boosting the voltage output from the ESS-PCS to a normal operation level.

Here, the fault processing method may further include a step of connecting the distributed energy resources to the microgrid after boosting the voltage output from the ESS-PCS to the normal operation level.

Here, the step of determining a location of the fault may include steps of: checking whether or not the ESS-PCS is normally operated as the ESS-PCS is connected to the microgrid; checking whether or not there is a fault in a line/load side by monitoring a current of the microgrid while gradually increasing a voltage supplied from the ESS-PCS if it is determined that the ESS-PCS is normally operated; checking whether or not there is a fault in each load section if a fault is recognized in the line/load section; and checking whether or not there is a fault in a line if a fault is not recognized in each load section.

Here, in the step of checking whether or not there is a fault in the line/load side, a change of the current depending on a gradual increase of the voltage may be compared with a normal operation state, and a fault in the line/load side may be determined if a remarkable change is recognized, compared to the change of the current of the normal state.

Here, the fault processing method may further include a step of checking whether or not an operation of gradually increasing the output voltage subsequent to occurrence of the fault is possible after the step of checking whether or not there is a fault in the ESS-PCS.

Using the ESS-PCS or the fault processing method according to the invention as described above, it is possible to stably operate the grid by rapidly removing a fault section and improve reliability of the microgrid system.

In the microgrid system having the ESS-PCS according to the invention, it is not necessary to provide a separate diesel generator for a fault test or a large-capacity diesel generator for each distributed energy resource.

Using the microgrid system provided with the ESS-PCS according to the invention, it is possible to minimize generated energy of the renewable energy resource that may be lost in the event of outage.

Using the microgrid system provided with the ESS-PCS according to the invention, it is possible to obtain easy maintenance in the microgrid system installed in a remote place such as an island area and provided with an independent grid without being interconnected to a separate external energy system

Using the ESS-PCS and the fault processing method according to the invention, it is possible to more effectively utilize the ESS whose capacity is increasing.

### BRIEF DESCRIPTION OF DRAWINGS

FIG. 1 is a block diagram illustrating a microgrid system having an ESS-PCS according to an idea of the present invention;
FIG. 2 is a block diagram illustrating an ESS-PCS applicable to the microgrid system of FIG. 1 according to an embodiment of the invention;
FIG. 3 is a flowchart illustrating a fault processing method executed in the management device and/or the ESS-PCS of FIG. 1;
FIG. 4 is a block diagram illustrating a connection structure of the ESS-PCS to the microgrid system, applicable to the processing of steps S20 and S30 of FIG. 3;
FIG. 5 is a flowchart illustrating a fault location detection method executed in step S50 of FIG. 3;
FIG. 6a is a graph illustrating a voltage and a current measured for off-grid boosting in a normal state;
FIG. 6b is a graph illustrating a voltage and a current measured for off-grid boosting in a fault state of the microgrid;
FIG. 7 is a flowchart illustrating a more specific process of sequentially executing an interconnection and fault check for distributed energy resources provided in the microgrid in step S555 of FIG. 5;
FIG. 8 is a flowchart illustrating a more specific process of a fault check for line sections in step S589 of FIG. 5;
FIGS. 9(a) to 9(c) are block diagrams illustrating operations from fault occurrence to a black start of a microgrid system according to an idea of the invention;
FIG. 10 is a graph illustrating voltage and current waveforms of a soft start in an active PCS according to an idea of the invention; and
FIG. 11 is a schematic diagram illustrating a gateway-integrated PCS applicable to a microgrid interconnected to an external grid of the prior art.

### DESCRIPTION OF EMBODIMENTS

Specific embodiments for embodying the present invention will now be described with reference to the accompanying drawings.

It will be understood that, although the terms "first, " "second, " etc. may be used herein to describe various elements, these elements should not be limited by these terms. These terms are only used to distinguish one element from another. For example, a first element could be termed a second element, and, similarly, a second element could be termed a first element, without departing from the scope of the present invention.

It will be understood that when an element or layer is referred to as being "on" or "connected to" another element or layer, the element or layer can be directly on or connected to another element or layer or intervening elements or layers.

The terms used in describing various embodiments of the disclosure are only examples for describing a specific embodiment but do not limit such embodiments. Singular forms are intended to include plural forms unless the context clearly indicates otherwise. Unless defined differently, all terms used herein, which include technical terminologies or scientific terminologies, have the same meaning as that understood by a person skilled in the art to which the disclosure belongs.

It will be further understood that the terms "comprises" and/or "comprising, " when used in this specification, specify the presence of stated features, integers, steps, operations, elements, and/or components, but do not preclude the presence or addition of one or more other features, integers, steps, operations, elements, components, and/or groups thereof.

In the drawings, shapes or sizes of the elements may be exaggerated in order to clearly illustrate features of the embodiments.

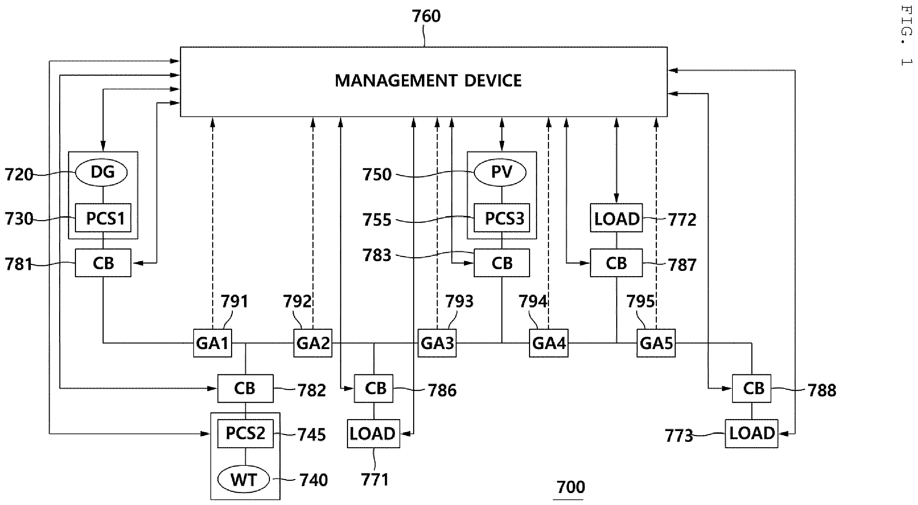

FIG. 1 is a block diagram illustrating a microgrid system 700 obtained by applying an ESS-PCS according to an idea of the invention.

The microgrid system 700 of FIG. 1 includes a plurality of distributed energy resources 740 and 750 for supplying energy to the grid, a plurality of distributed loads 771, 772, and 773 that consume energy in the grid, lines that connect the distributed energy resources 740 and 750 and the distributed loads 771, 772, and 773 to the grid, and an energy storage system (ESS) 720 that stores energy supplied from a part or all of the distributed energy resources 740 and 750 and provide the stored energy to a part or all of the distributed loads 771, 772, and 773.

All or a part of the plurality of distributed energy resources 740 and 750 and the distributed loads 771, 772, and 773 may have respective circuit breakers 781 to 788 capable of selectively connecting or disconnecting the grid.

Although it is recommended that the lines ideally have the same electrical property (electric potential) for the plurality of distributed energy resources 740 and 750 and distributed loads 771, 772, and 773 connected to the grid, the lines have different electrical properties (such as electric potential or current) depending on each location due to imbalance of the supplied energy and/or loads and internal impedance of a long line.

Specific spots in the middle of the lines may have electric property measurement units 781 to 783 (such as a current meter, a voltage meter, a current transformer, and a hall sensor) in order to monitoring the different electrical properties.

For example, the measurement units may be provided in every connection node between the plurality of distributed energy resources 740 and 750 and distributed loads 771, 772, and 773 or may be provided on a predetermined length basis.

Depending on implementations, a part or all of the plurality of distributed energy resources 740 and 750 and distributed loads 771, 772, and 773 may have a measurement unit or a monitoring unit for monitoring an operation state and/or electrical property.

Recently, the ESS 720 has a lithium secondary battery as a configuration for relieving an energy burden depending on an ununiform load demand in the microgrid in some cases . Alternatively, the ESS 720 may have any other energy storage unit known in the art.

The plurality of distributed energy resources 740 and 750 have the PCSs 745 and 755, respectively, and the plurality of distributed loads 771, 772, and 773 also have the circuit breakers 786, 787, and 788, respectively. However, since the functions of the present invention are implemented by the PCS 730 of the ESS 720 and the circuit breaker 781 that connects/disconnects the PCS 730 to/from the grid, the PCS 730 of the ESS 720 and the circuit breaker 781 will be described below in more details.

The PCS 730 of the ESS 720 may also be referred to as "ESS-PCS". The ESS-PCS 730 converts the energy stored in the ESS 720 into AC (or DC) power suitable for the microgrid, supplies the power to the microgrid system, and has a circuit breaker 781 that disconnects the microgrid system under an abnormal situation such as outage or short-circuiting.

The ESS-PCS 730 may perform a power phase synchronization function for synchronizing a power phase of the grid and a phase of the power output from the PCS to the grid, a function of adjusting electrical energy (that is, magnitude of voltage and/or current) supplied to the grid, and a surge relief/protection function for relieving and/or cutting off transmission of a danger factor such as a surge generated in the grid side to the ESS 720, and may have elements for these functions. The aforementioned functions have been disclosed in many literatures as a PCS technology in the field of ESS, and will not be described here for simplicity purposes.

In the drawings, photovoltaic (PV) resources and wind turbines (WT) are illustrated by way of example as the distributed energy resources.

In the aforementioned description regarding the structure and the following description regarding the method, the management device 760 causes the circuit breaker 781 to operate for a system fault solution and fault location detection. However, it would be appreciated that, in practice, the management device 760 instructs the active PCS 730 to perform the operation for the circuit breaker 781, and the active PCS 730 operates the circuit breaker 781 in response to this instruction.

When a fault occurs in the microgrid system connected to the ESS 720 in the configurations for the power phase synchronization function and the surge relief/protection function of the ESS-PCS 730 described above, the ESS-PCS 730 may be disconnected from the grid for a while. In order to protect the ESS-PCS 730 itself in such a temporary disconnection process and the fault location detection process according to an idea of the invention, an insulated gate bipolar transistor (IGBT) provided in the ESS-PCS 730 (more specifically, the IGBT included in the inverter) advantageously has an open time of approximately several hundreds of microseconds or shorter.

The ESS-PCS 730 according to an idea of the invention can advantageously adjust the electrical energy as a continuously value as possible in the function of adjusting the electrical energy supplied to the grid. Even when the electrical energy is adjusted discontinuously or stepwise, it is advantageous that the steps are specific as possible. For example, the ESS-PCS 730 illustrated in the drawings can gradually increase the current to the maximum current (ESS rated current) that can flow to the grid from 0 [A] or a 80% level of the rated current defined for the distributed loads connected to the grid (the voltage also increases to the corresponding level in the case of no fault) for a predetermined test time in the event of a start (for example, a predetermined period of time for 1 to 3 seconds).

The ESS-PCS 730 according to an idea of the present invention can adjust the electric energy output to the grid depending on the connection states of the plurality of distributed energy resources 740 and 750 and the plurality of distributed loads 771, 772, and 773 to the microgrid system. This function may be implemented by applying the ESS and/or PCS technique for configuring a smart grid system known in the art.

The ESS-PCS may gradually increase the voltage output for a predetermined time (for example, a predefined period of time of 1 to 3 seconds) by re-connecting the disconnected ESS to the grid and sequentially increasing the voltage from 0 V to a predetermined voltage level for a predetermined time (for example, a predefined period of time of 1 to 3 seconds) in an initial stage. In this case, most preferably, a relationship between time and voltage continuously makes a first-order function (linear function having a predetermined slope). However, in a practical application, the relationship between time and voltage may be discrete and/or non-linear under the condition that the time and the voltage increase proportional to each other.

Here, the spot serving as a voltage and current measurement reference is preferably an output terminal of the ESS-PCS (node connected to the grid), but not limited thereto.

As a method of gradually increasing the voltage output for a predetermined time as described above in the ESS-PCS, a typical ES-PCS function of the prior art may be employed. As a method of gradually increasing the output voltage, for example, in the case of the ESS having a plurality of battery cells, it may be possible to sequentially increasing the number of cells used to produce the output power out of the supplemented battery cells. Alternatively, when a temporary energy storage unit such as a super-capacitor is separately employed to supply the energy stored in the ESS battery to the grid, the output voltage can be adjusted by controlling the capacity of the temporary energy storage unit and/or the number of the unit cells. Alternatively, a transformer having a multi-stage tap capable of discontinuously increasing the output voltage level may also be employed.

The microgrid system 700 implemented with the ESS-PCS according to an idea of the invention as illustrated in FIG. 1 may further include a management device 760 that determines a fault location in the microgrid system using the ESS-PCS 730 and performs a black start as a subsequent solution for the fault.

The management device 760 is advantageously installed in a central control site of the microgrid system 700 and is also advantageously located in the same place as that of the ESS 720 or the vicinity thereof for actively using the ESS 720 and the ESS-PCS 730.

The management device 760 may perform data (signal) communication with the ESS 720, the ESS-PCS 730, the distributed energy resources 740 and 750, and the distributed loads 771, 772, and 773, and the measurement units 791 to 795 or the monitoring unit provided on the lines. For this purpose, the management device 760 may have a wired/wireless communication unit that uses a power line communication unit or a separate power line and an independent medium accessible to each measurement unit or the monitoring unit.

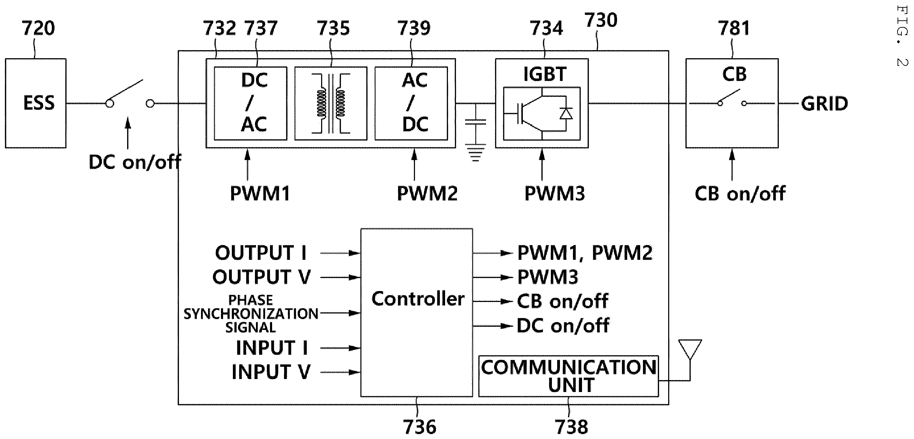

FIG. 2 is a block diagram illustrating a PCS applicable as the ESS-PCS 730 of FIG. 1 according to an embodiment of the invention.

The illustrated ESS-PCC 730 is supplied with the power remaining in the grid and stores it. The ESS-PCS 730 serves as a PCS that converts and relays power between the ESS 720 that provides the stored energy and the grid when the power is insufficient in the grid, so that the energy of the grid can be charged in the battery of the ESS 720, and the energy charged in the battery can be discharged to the grid.

The illustrated configuration of the ESS-PCS 730 has a DC/DC converter 732 interposed between the ESS 720 and the interconnection type inverter 743 for controlling effective power input/output to the ESS 720, so that the DC voltage of the inverter 743 can be constantly maintained, and the DC voltage of the ESS 720 can be adjusted on the basis of the duty ratio of the DC/DC converter 732. In the power conditioning structure of this type, freedom in control is high, so that the AC input current and the battery charge/discharge current can be independently controlled, and harmonic waves of the input current can be reduced.

The illustrated ESS-PCS 730 may have a circuit breaker 781 that cuts off connection to the grid and a control device 736 that detects a fault location while gradually increasing a voltage output to the grid where the fault is detected as the fault is detected from the grid.

As a configuration for performing the function of converting the power stored in the ESS 720 into AC power suitable for the microgrid and supplying the power to the microgrid, the ESS-PCS 730 may have a DC/DC converter 732 for converting the DC power output from the ESS 720 into DC power having a desired voltage and/or current and an inverter 734 for converting the DC power output from the DC/DC converter 732 into AC power.

The DC/DC converter 732 may be a DC/DC converter having a structure in which the DC/AC conversion circuit 737, the insulation transformer 735, and the AC/DC conversion circuit 739 are connected in series. The DC/AC conversion circuit 737 and the AC/DC conversion circuit 739 may have a switching element (such as an IGBT) operating in the pulse width modulation (PWM) scheme, so that the voltage of the energy output from the ESS 720 to the grid can be adjusted on the basis of the PWM scheme. The insulation transformer 735 performs the AC power transmission function for the DC/AC conversion circuit 737 and the AC/DC conversion circuit 739 and a function of cutting off an ESS-grid surge, short-circuiting, or the like.

The control device 736 may generate a PWM1 signal for controlling operations of the switching elements of the DC/AC conversion circuit 737 for DC/DC conversion and a PWM2 signal for controlling operations of the switching elements of the AC/DC conversion circuit 739.

The control device 736 may generate a DC on/off signal for controlling a DC terminal circuit breaker that switches on/off connection between the ESS 720 and the PCS 730 and a CB on/off signal for controlling a circuit breaker 781 that switches on/off connection between the PCS 730 and the grid.

The control device 736 may receive a phase synchronization signal input from the outside or generated inside the PCS and generate a PWM3 signal for driving the power switching element IGBT of the inverter 743.

The control device 736 may receive the input voltage value (input V) and the input current value (input I) from the voltage sensor and the current sensor provided in an ESS-side input terminal and receive the output voltage value (output V) and the output current value (output I) from the voltage sensor and the current sensor provided in the grid-side output terminal.

The control device 736 may compute a power factor by measuring the grid voltage and current and control the operations of the DC/DC converter 732 and the inverter 743 to maintain the power factor at 0.95 or greater.

In another implementation, the control device 736 may measure a voltage (capacitor voltage) of the DC link between the DC/DC converter 732 and the inverter 743 and control the inverter 743 depending on the measurement result. Specifically, if the voltage of the DC link is lower than a reference level, the control device 736 may control the inverter 743 so as to convert the AC power of the grid into DC power and transmits the DC power to the DC link. Meanwhile, if the voltage of the DC link is higher than the reference level, the controller 150 may control the inverter 110 so as to convert the DC power charged in the DC link into AC power and transmit the AC power to the grid. In addition, in a charging mode, the control device 736 may measure the current of the DC link (the inverter current which is not shown) and bidirectionally control the DC/DC converter 732 so as to constantly maintain the measured current.

Depending on implementations, the ESS-PCS 730 may further include a grid phase detection circuit (not shown) for detecting a phase of the power supplied to the grid and generating the phase synchronization signal and a data communication unit 738 for transmitting information regarding the result of the fault location detection according to an idea of the invention to the management device of FIG. 1.

Although the circuit breaker 781 and the DC terminal switch connected to the grid are not included in the ESS-PCS 730 in the drawings, the circuit breaker 781 and/or the DC terminal switch connected to the grid may be regarded as being included in the ESS-PCS 730 from some viewpoints, considering a fact that the circuit breakers CB are installed in the vicinity of a power input/output device.

Although not shown in the drawings, the ESS-PCS 730 may further include an additional resonance tank circuit for facilitating zero-voltage switching (ZVS) and zero-current switching (ZCS) or a DC link between the DC/DC converter 732 and/or the inverter 743 in order to reduce a switching loss of the switching element included in the DC/DC converter 732 and/or the inverter 743.

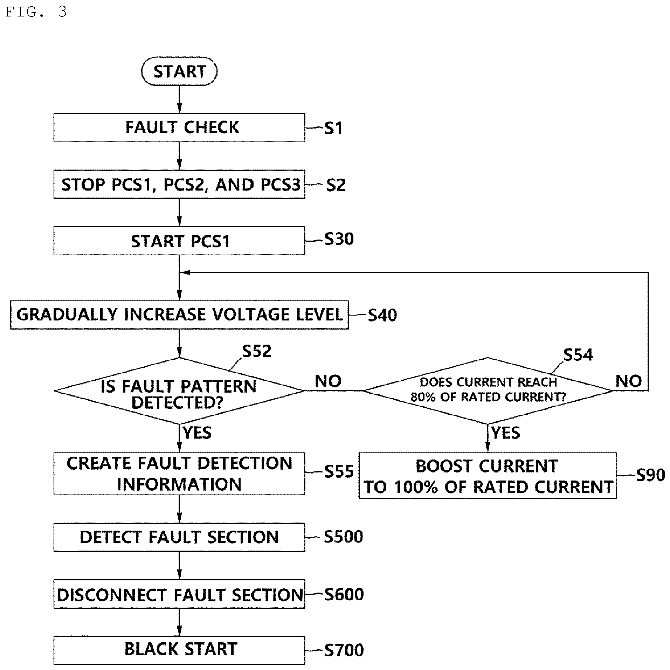

FIG. 3 is a flowchart illustrating a fault processing method executed by the management device 760 of FIG. 1 and the control device 736 of FIG. 2. That is, depending on implementations, the fault processing method of the flowchart may be performed by the control device 736 of the ESS-PCS of FIG. 2 or the management device 760 of FIG. 1 or may be performed by both the devices 736 and 760 in a shared/combined manner. In the following description, it is assumed that the fault processing method is performed in a shared/combined manner.

The illustrated fault processing method may include a fault detection process (S1) for detecting a fault in the microgrid system, a grid disconnection process (S2) for disconnecting the distributed energy resources and the ESS, a process (S30) of connecting the ESS-PCS to the microgrid system, a process (S40) of gradually increasing a voltage output from the connected ESS-PCS, a process (S52, S54, and S500) of determining a fault location, a process (S600) of disconnecting the fault location, and a process (S700) of connecting the distributed energy resources to the microgrid.

The fault detection step S1 may be independently performed by each of the distributed energy resources and the ESS-PCS connected to the microgrid system. That is, as a self protection function for protecting each of the distributed energy resources and the ESS that allow each PCS to be connected to the grid, a fault occurring in the microgrid system may be detected. The PCS that detects the fault may report it to the management device using a data communication unit.

The grid disconnection step (S2) may be performed on the basis of the PCS internal function in the case of the PCS that detects the fault or in response to a shutdown command of the management device that receives a report of the fault in the case of the PCS that has not detected the fault.

Although only the PCSs connected to the grid are disconnected from the grid in the grid disconnection step (S2) in the drawings, in another implementation, the distributed loads and the distributed energy resources that do not have the internal PCS may also be disconnected using the management device.

The illustrated steps S52 to S55 are a process of checking whether or not a fault occurs in the distributed load side using the ESS-PCS (more specifically, the control device). The illustrated step S500 is a process of checking whether or not a fault occurs and a location of the fault in the distributed energy resources or the line side rather than the distributed load side.

The steps S40 to S500 will be described with reference to the following drawings.

The step S600 is performed for disconnecting the section determined as a fault in the steps S55 and S500 from the grid. Specifically, the distributed energy resource or the distributed load determined as a fault may be disconnected by switching off the circuit breaker.

The step S700 is a process for restarting the microgrid while only the fault section is disconnected from the grid before perfect fault recovery under the faulted state and is also called "black start". In the step S700, if the disconnection of the fault section from the grid is recognized (S600), first, the ESS-PCS is connected to the microgrid system to supply power to a serviceable section. Then, the PCSs of the disconnected distributed energy resources PV/WT can be sequentially connected to the microgrid system.

In the drawings, the steps S1, S2, S500, S600, and S700 may be performed by the management device 760 of FIG. 1 as a main body in cooperation with the control device 736 of the ESS-PCS. In the drawings, the steps S30 to S55 and S90 may be performed by the control device 736 of the ESS-PCS as a main body, and the results thereof may be reported to the management device 760 of FIG. 1.

The steps S52 and S54 for determining the fault location are performed by the control device 736 of FIG. 2, and may further include a step S52 of checking whether or not there is a fault pattern in the output voltage value and the output current value of the PCS, a step S55 of generating fault detection information if the fault pattern is recognized, a step S54 of determining whether or not the current value reaches 80% of the rated current if there is no fault pattern, and a step S90 of boosting the current to 100% of the rated current if the current value reaches 80% of the rated current (in this case, fault non-detection information is created in step S55, and the process subsequent to step S500 is executed) . The step S90 is executed in cooperation with the step S700.

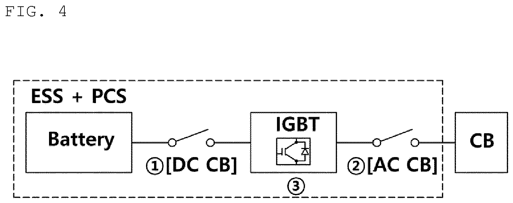

FIG. 4 illustrates a connection structure of the ESS-PCS to the microgrid system applicable to execute the steps S2 and S30 according to an embodiment of the invention.

As the illustrated connection structure of the ESS-PCS to the microgrid system, the circuit breaker may include a DC terminal switch (DC CB) that switches on/off connection between the battery of the ESS and the PCS inverter, an AC terminal switch (AC CB) that switches on/off connection between the inverter of the ESS-PCS and the microgrid, and an IGBT switching unit that switches on/off the IGBT of the inverter (this function may be performed in cooperation with the control device 736 of FIG. 2).

As illustrated in the drawings, the battery of the ESS may be switched on/off to the inverter using the DC terminal switch (DC CB), and the inverter may be switched on/off again to the ESS circuit breaker (CB 781 in FIG. 1) or the microgrid system using the AC terminal switch (AC CB). In the sequence of re-connecting the ESS-PCS that has been disconnected from the grid due to a fault generated in the grid to the grid, first, the DC terminal switch (DC CB) is closed, the AC terminal switch (AC CB) is then closed, and the IGBT of the inverter is then closed depending on the DC-AC conversion operation.

The following Table 1 shows a reference of the fault location detection executed in the fault location detection step S50.

**[Table 1]**

| | |
|---|---|
| Fault in active PCS side | Determination on whether or not the active PCS is operated (in the case of a fault, the PCS is not operated) |
| Fault in installed distributed energy resource or instantaneous fault | Boosting to an off-grid system is possible (it is determined that there is no fault section in the boosted grid) |
| | → sequentially interconnect the installed distributed energy resources (it is determined that the distributed energy resource is faulted if outage occurs due to the interconnected distributed energy resource) |
| Fault in line | •For a line fault section |
| | - difference of the current around measurement occurs |
| | - difference of the current around measurement is the current flowing through the fault location |
| | • For other line sections |
| | - difference of the current around measurement is insignificant |
| Fault in load section | • determine a fault section by comparing a value measured in the terminated end with a setting value |
| | - measured value > (setting value)×0.5 (changeable) |
| | ex) If the rated capacity of the ESS is "1 M", the factor may be set to "0.8". |
| | If the rated capacity of the ESS is "2 M", the factor may be set to "0.7". |

The references described in the aforementioned table may be applied to the fault location detection method described below.

Referring to the aforementioned table, the word "around" of the phrase "difference of the current around measurement in the line fault section" as a basis of determination on a fault in a line may include preceding and following spots with respect to a location on the line of each measurement spot after occurrence of the fault.

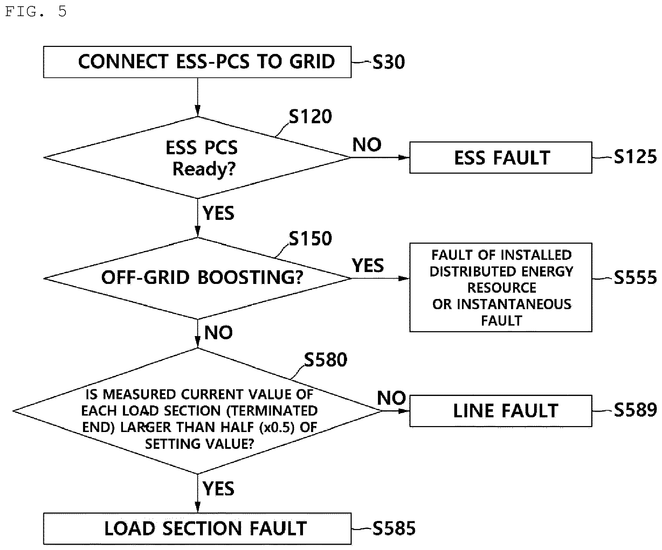

FIG. 5 is a flowchart illustrating a fault location detection method executed in the fault location detection process including steps S52 to S55 according to an embodiment of the invention.

The illustrated fault location detection method may include a process (step S120) of checking whether or not the ESS-PCS itself is normally operated when the ESS-PCS is connected to the microgrid system (S30), a process (step S150) of checking whether or not there is a fault in the line/load-side by monitoring the current of the microgrid while gradually increasing the voltage supplied from the ESS-PCS to the grid if the ESS-PCS is normally operated, a process (step S580) of checking whether or not there is a fault in each load section if there is a fault in the line/load-side, and a process (step S589) of checking whether or not there is a line fault if no fault is recognized in each load section.

The illustrated flowchart is executed as the process (step S30) of connecting the ESS-PCS to the microgrid system in FIG. 3 is executed. The step S30 in the drawings refers to the step S30 of FIG. 2.

If the ESS-PCS or the ESS is not normally operated in the process (S120) of checking whether or not the PCS is normally operated, it is determined that the ESS is faulted, and the process is terminated (S125). Any typical technique used in the ESS-PCS may be applicable to the process of checking whether or not the ESS-PCS is normally operated. For example, if a difference between the input power value computed by the control device 736 of FIG. 2 on the basis of the input voltage value (input V) and the input current value (input I) and the output power value computed on the basis of the output voltage value (output V) and the output current value (output I) is significant, it may be determined that the PCS itself is faulted. Here, the measurement spot for the input voltage value (input V) and the input current value (input I) may be in the vicinity of the DC terminal switch (DC CB) of FIG. 4, and the measurement spot for the output voltage value (output V) and the output current value (output I) may be in the vicinity of the AC terminal switch (AC CB) .

Depending on implementations, the method may further include a process of checking whether or not power sufficient to perform a soft start (off-grid boosting) and/or a black start to the grid according to an idea of the invention is stored in the ESS after checking whether or not the ESS-PCS itself is normally operated in the step S120. This process considers a fact that significant power to the grid is required for a soft start or the like in order to check whether or not there is a fault in the entire grid.

In the process (S150) of checking whether or not there is a fault in the line/load side, the operation of gradually increasing the voltage/current supplied from the ESS PCS to the grid means that the step S40 of FIG. 3 is executed.

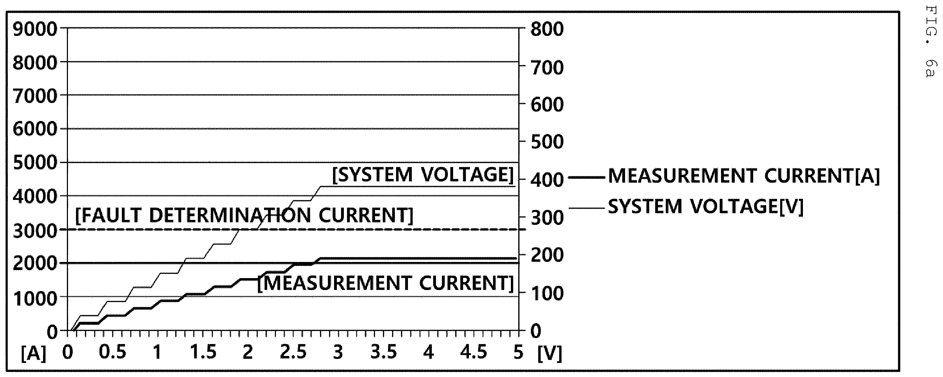

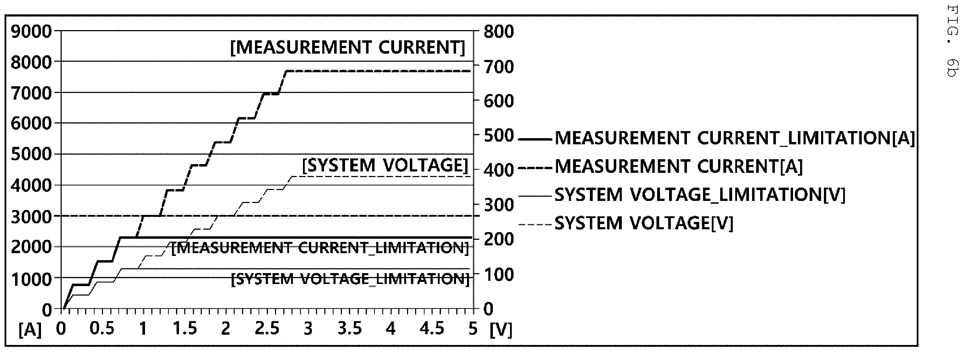

The operation of the step S150 for gradually increasing the voltage supplied from the ESS-PCS to the grid may be called "off-grid boosting". FIG. 6a is a graph illustrating the voltage and the current measured for the off-grid boosting in a normal state, and FIG. 6b is a graph illustrating the voltage and the current measured for the off-grid boosting when a fault occurs in the microgrid.

Referring to both the graphs, the grid voltage is "380 V", and the entire load is "1.5 M". In addition, the capacity of the ESS-PCS is "2.0 M". As a specific fault example, FIG. 1 illustrates a case where the load 2 (772) suffers from a one-line ground fault.

Referring to the voltage/current graph having the faulted state in the drawings, it is recognized that the current approaches 80% of the fault determination current (approximately 2.4 kA) when the voltage increases to approximately 114 V (rated current: approximately 3.0 kA). That is, when a fault occurs in the microgrid system, an increase of the grid current depending on an increase of the voltage supply is significant, compared to a normal state (as a result, the current reaches 80% of the fault determination current). This may be generated when the load-side impedance of the grid becomes lower than a normal state due to a leakage, a ground fault, or short-circuiting in a load or line. As a method of checking whether or not there is a fault in the line/load side using the phenomenon exhibiting in both the graphs, a fault of the line/load side may be determined if a change of the current depending on a gradual increase of the voltage is remarkably higher than a change of the current of the normal state. Here, the fault determination current is a reference current amount sufficient to determine the fault and may be a current amount at which the power can be uniformly distributed to the line/load side connected to the grid without a problem. Meanwhile, this current may be applied to the maximum current that can be generally supplied to the grid connected to the line/load side from the ESS-PCS.

In the step S30 of FIG. 3, the distributed energy resources have not been connected. Therefore, if the off-grid boosting is suitable, it can be determined that this is not a fault caused by the distributed energy resource.

If it is checked in the step S150 that boosting can be performed for the off-grid system, that is, if fault non-detection information is created in the step S55 of FIG. 3, it may be determined that there is no fault section in the boosted grid (in the distributed loads connected to the grid in the step S30), and an interconnection and fault check may be sequentially performed for the installed distributed energy resources in the step S555. For example, when outage occurs again in any one of the interconnected distributed energy resource, it can be determined that this is a fault caused by the corresponding distributed energy resource. Here, a fact that the boosting is possible for the off-grid system means that a voltage-current pattern corresponding to the graph of FIG. 6a is exhibited.

If the off-grid boosting is not appropriately performed in the step S150, the operations subsequent to the step S580 for measuring a magnitude/direction of the current of the line section and the load side are executed. In this case, a process of transmitting information regarding the fault location detection to the management device of the grid may be further executed. Here, the information regarding the fault location detection may include only whether or not the off-grid boosting is failed, a output voltage/current value at the time of determination of the failure, or a voltage/current pattern determined as a failure.

In the step S580, the current values measured at the terminated ends of each load section are compared with a predefined setting value. If the measured current value is higher than a predetermined ratio, it is determined that the corresponding load section is faulted. In other words, in the step S320, the current values measured at the terminated ends of each load section are compared with the setting value to determine a fault section. For example, if the measured value is higher than a half (×0.5) of the setting value (changeable), the corresponding section may be determined as a fault. Meanwhile, if the ESS has a rated capacity of "1 M", the factor multiplied to the setting value may be set to "0.8". If the ESS has a rated capacity of "2 M", the factor multiplied to the setting value may be set to "0.7". In this manner, the multiplication factor may be adjusted depending on the capacity of the ESS.

In the step S589, in the case of the line fault section, the difference of the current around measurement is used. In this case, the difference of the current around measurement may be estimated as a current flowing through the fault spot. In the case of a normal line section having no fault, the difference of the current around measurement is insignificant.

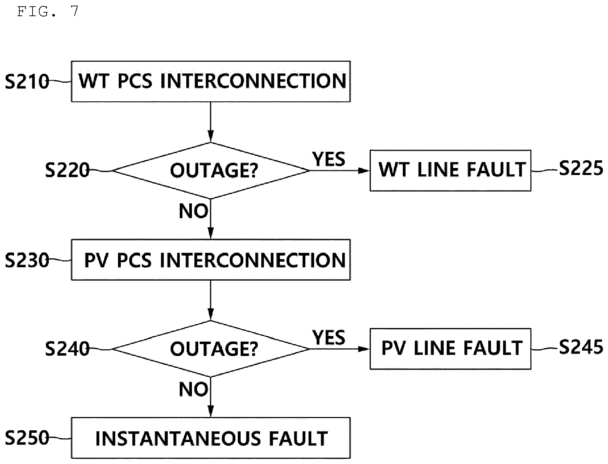

FIG. 7 is a flowchart illustrating a more specific process for sequentially performing an interconnection and fault check for the distributed energy resources provided in the microgrid in the step S555 of FIG. 4. In FIG. 7, it is assumed that a distributed energy resource disconnected from the microgrid system due to a fault merely includes a photovoltaic resource PV or a wind turbine WT when the distributed energy resources provided for a check following a fault are sequentially interconnected.

The method of checking the distributed energy resources illustrated in the drawing may include a process of connecting the PCS of the wind turbine WT to the grid (S210) and checking whether or not outage occurs (S220), a process of, if no outage occurs in the wind turbine WT, connecting the PCS of the photovoltaic resource PV to the grid (S230) and checking whether or not outage occurs (S240), and a process of determining an instantaneous fault if no outage occurs in the photovoltaic resource PV.

If occurrence of outage is recognized in the step S220, a line fault of the wind turbine WT may be determined (S225) . If occurrence of outage is recognized in the step S240, a line fault of the photovoltaic resource PV may be determined (S245).

In the drawings, the wind turbine WT is checked, and then, the photovoltaic resource PV is checked. However, the check sequence may be changed.

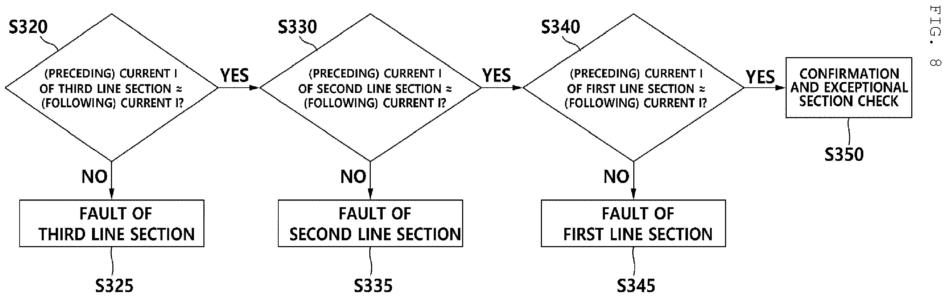

FIG. 8 is a flowchart illustrating a more specific process of checking a fault in the line sections in the step S189 of FIG. 4. The drawing was drawn by assuming that there are only first to third line sections.

The illustrated line section check method may include a process of checking whether or not the current of the third line section prior to measurement is nearly equal to the current subsequent to measurement (in practice, this means that both the currents belong to a range regarded as being equal) (S320), a process of checking whether or not the current of the second line section prior to measurement is nearly equal to the current subsequent to measurement if the current of the third line section around measurement is nearly equal (S330), a process of checking whether or not the current of the first line section prior to measurement is nearly equal to the current subsequent to measurement if the current of the second line section around measurement is nearly equal (S340), and a process of confirmation and/or checking an exceptional section (excluded section) if the current of the first line section around measurement is nearly equal (S350).

If it is checked that the current around measurement is different in the step S320, a fault of the third line section may be determined (S325). If it is checked that the current around measurement is different in the step S330, a fault of the second line section may be determined (S335). If it is checked that the current around measurement is different in the step S340, a fault of the first line section may be determined (S345).

Similar to the previous description for Table 1, the word "around" of the phrase "difference of the current around measurement in the line fault section" as a basis of determination on a fault in a line may include preceding and following spots with respect to a location on the line of each measurement spot after occurrence of the fault.

In the drawing, the check is performed in order of the third, second, and first line sections. However, the check sequence may be changed in any way.

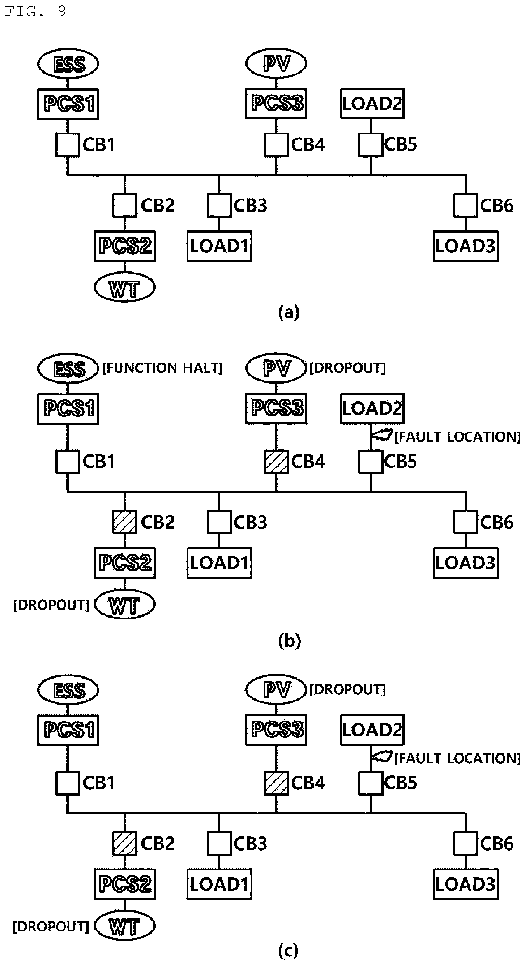

FIGS. 9(a) to 9(c) are block diagrams illustrating operations performed from occurrence of a fault to a black start of the microgrid system according to an idea of the invention. In the drawings, the green color of the circuit breaker CB means a connected state, and the red color indicates a disconnected state. The gray color of the energy resource indicates a function halt state.

As illustrated in FIG. 9(a), in the normal state, most of the circuit breakers in the microgrid are closed, and the ESS is also connected to the microgrid system via the closed circuit breaker regardless of its operation state.

Referring to FIG. 9(b), if a dropout occurs in the second load, the ESS having its internal PCS and each distributed energy resource (including PV and WT) are disconnected from the microgrid system by virtue of the circuit breaker CB and/or an its internal protection function of the PCS.

In FIG. 9(c) in which a trouble solution according to an idea of the invention is performed, the ESS-PCS is connected to the microgrid system, and the voltage of the grid is gradually boosted by operating the ESS while the distributed energy resources (including PV and WT) are still disconnected from the grid.

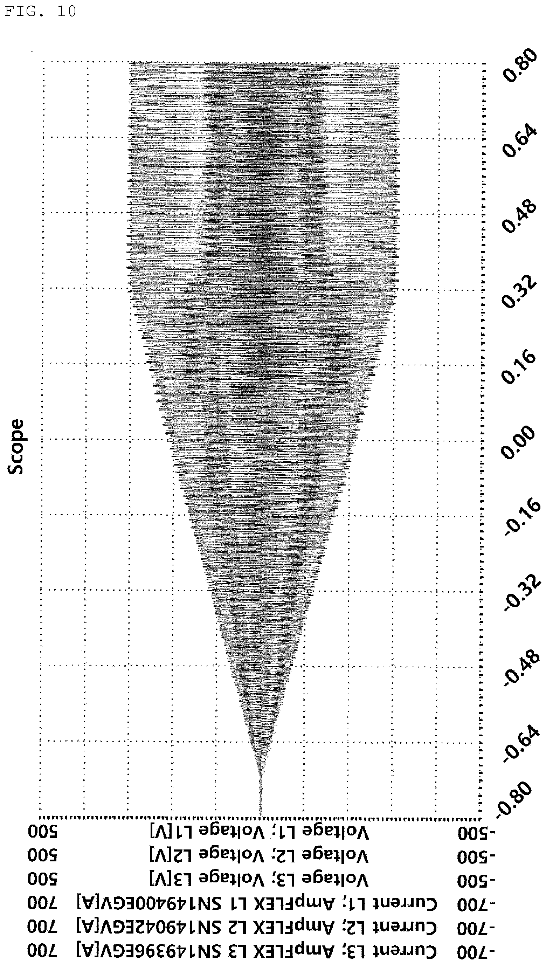

FIG. 10 illustrates voltage/current waveforms in a soft start of the ESS-PCS according to an idea of the invention.

That is, FIG. 10 illustrates voltage/current waveforms at the output terminal of the ESS when the output voltage gradually increases from 0 V to the rated voltage for approximately one second as a soft start function of the PCS of the battery.

The soft start operation of the ESS-PCS described above may be combined with a black start in which the fault section is disconnected from the grid, and the microgrid starts again. As a system condition for the black start, it may be required to inactivate the function of the VCB-side UVR relay during the black start and to start the ESS-PCS after the UVR relay is inactivated, and all of the circuit breakers are activated.

While the embodiments of the invention have been described for illustrative purposes, it should be noted that the embodiment is not construed to limit the scope of the invention. Furthermore, those skilled in the art could understand that various changes or modifications are possible within the spirit and scope of the technical concept of the invention.

### [Reference Signs List]

- 700: : microgrid system
- 730: : ESS-PCS
- 732: : DC/DC converter
- 734: : inverter
- 736: : control device
- 740, 750: : distributed energy resources
- 760: : management device
- 771, 772, 773: : distributed loads
- 781 to 788: : circuit breaker
- 781 to 785: : measurement unit

### [Industrial applicability]

The present invention relates to an ESS-PCS for performing fault processing and a method of operating the PCS, and is applicable to an energy storage field.

## Claims

1. A power conditioning system (PCS) for an energy storage system (ESS) that receives and stores power remaining in a grid and provides the stored power in a power shortage state of the grid, the ESS-PCS performing power conditioning and mediation in the grid, the ESS-PCS comprising:
a circuit breaker configured to disconnect a line connected to the grid; and
a control device configured to detect a fault in the grid and check a location of the fault while gradually increasing a voltage of power output to the grid where the fault is detected.

2. The ESS-PCS according to claim 1, wherein the control device boosts the voltage of the power output to the grid, that has gradually increased for the fault location detection, to a normal operation level depending on a location of the fault and a processing result.

3. The ESS-PCS according to claim 1, wherein the control device determines a location of the fault in a microgrid while gradually increasing the voltage output from the active PCS immediately after re-connection to the grid that has been disconnected due to occurrence of the fault, and transmits information regarding the determined location to a management device.

4. The ESS-PCS according to claim 1, wherein the control device performs a PCS operation method including steps of
disconnecting a line connected to the grid when a fault is detected in the grid,
checking whether or not the ESS-PCS is normally operated,
connecting the ESS-PCS to the grid and determining a location of the fault while gradually increasing a voltage output to the connected grid,
transmitting information regarding the fault location detection to a management device of the grid, and
boosting the voltage output to the grid to a normal operation level in response to an instruction of the management device.

5. The ESS-PCS according to claim 4, wherein the step of determining a location of the fault includes steps of
checking whether or not the PCS is normally operation as the ESS-PCS is connected to the grid, and
checking whether or not there is a fault in a line/load side by monitoring a current of the grid while gradually increasing a voltage supplied to the ESS-PCS if it is determined that the ESS-PCS is normally operated.

6. The ESS-PCS according to claim 4, wherein the step of connecting the ESS-PCS to the grid includes
closing a DC terminal switch that switches on/off connection between an inverter and a battery of the ESS,
closing an AC terminal switch that switches on/off connection between a microgrid and an inverter of the ESS, and
closing an Insulated gate bipolar transistor (IGBT) included in the inverter.

7. The ESS-PCS according to claim 1, further comprising a data communication unit configured to transmit information regarding the location of the fault to a management device.

8. A fault processing method of a microgrid having a plurality of distributed energy resources, a plurality of distributed loads, lines that connect the distributed energy resources and the distributed loads, and an energy storage system (ESS) that stores power supplied from a part or all of the distributed energy resources and supplies the stored power to a part or all of the distributed loads, the fault processing method comprising steps of:
disconnecting the distributed energy resources and an ESS power conditioning system (ESS-PCS) responsible for the ESS when a fault is detected in the microgrid system;
connecting the ESS-PCS to the microgrid;
determining a location of the fault while gradually increasing a voltage output from the ESS-PCS; and
disconnecting the location of the fault and boosting the voltage output from the ESS-PCS to a normal operation level.

9. The fault processing method according to claim 8, further comprising a step of connecting the distributed energy resources to the microgrid after boosting the voltage output from the ESS-PCS to the normal operation level.

10. The fault processing method according to claim 8, wherein the step of determining a location of the fault includes steps of
checking whether or not the ESS-PCS is normally operated as the ESS-PCS is connected to the microgrid;
checking whether or not there is a fault in a line/load side by monitoring a current of the microgrid while gradually increasing a voltage supplied from the ESS-PCS if it is determined that the ESS-PCS is normally operated;
checking whether or not there is a fault in each load section if a fault is recognized in the line/load section; and
checking whether or not there is a fault in a line if a fault is not recognized in each load section.

11. The fault processing method according to claim 10, wherein, in the step of checking whether or not there is a fault in the line/load side,
a change of the current depending on a gradual increase of the voltage is compared with a normal operation state, and
a fault in the line/load side is determined if a remarkable change is recognized, compared to the change of the current of the normal state.

12. The fault processing method according to claim 10, further comprising a step of checking whether or not an operation of gradually increasing the output voltage subsequent to occurrence of the fault is possible after the step of checking whether or not there is a fault in the ESS-PCS.
